# EUROPEAN PATENT APPLICATION

(11) **EP 2 407 794 A1**
(43) Date of publication of application: **18.01.2012**
(21) Application number: 09841521.9
(22) Date of filing: 19.11.2009
(51) Int. Cl.: G01R 31/02, H03K 19/00, H05K 3/00

(54) **ELECTRONIC CIRCUIT AND ELECTRONIC DEVICE**

(30) Priority: 11.03.2009 JP 2009058161
(71) Applicant: Sharp Kabushiki Kaisha, Osaka-shi, Osaka 545-8522 (JP)
(72) Inventor: KAWASE, Nobuyuki, Osaka-shi, Osaka 454-8522 (JP); OKASAWARA, Isao, Osaka-shi, Osaka 454-8522 (JP); IKUTA, Kazuhide, Yonago-sji, Tottori 689-3524 (JP)
(74) Representative: Goddar, Heinz J.
(86) International application number: PCT/JP2009/069650
(87) International publication number: WO 2010/103696

(57) **Abstract**

An electronic circuit of the present invention includes: a plurality of electronic parts, of the plurality of electronic parts, at least one electronic part being at least one main part (101a, 102a, and 103a) and the other electronic parts being auxiliary parts (101b, 102b, and 103b), the at least one main part (101a, 102a, and 103a) being necessary for determination of whether or not the electronic circuit operates normally, the auxiliary parts (101b, 102b, and 103b) being unnecessary for determination of whether or not the electronic circuit operates normally, the auxiliary parts (101b, 102b, and 103b) being connected to a line which is connected to the at least one main part (101a, 102a, and 103a) so as to supply a signal necessary for operation of the at least one main part (101a, 102a, and 103a) or output a signal obtained by the operation of the at least one main part. This provides an electronic circuit which is capable of properly detecting a circuit wiring disconnection and easily detecting faulty wiring between elements without the need of providing the electronic circuit with more components for detecting a circuit wiring disconnection.

## Description

### Technical Field

The present invention relates to an electronic circuit including a plurality of electronic parts.

### Background Art

In an electronic circuit including a plurality of electronic parts, in order to carry out an operation check, it is necessary to detect a malfunction in each of the plurality of electronic parts and/or a wiring disconnection.

For example, Patent Literature 1 discloses the following technique. A light emitting element of an optically coupled device is connected in series to a constant current output line of a constant current power supply circuit which is a kind of electronic circuit, and a voltage generated in a light receiving element is detected, so that it is detected by a simple and inexpensive arrangement whether or not a disconnection occurs in the constant current output line.

Patent Literature 2 discloses the following technique. An electronic circuit is arranged such that a plurality of inverters are connected in series between input-output terminals on a semiconductor substrate, so as to connect a test pad to an intermediate inverter and detect a wiring disconnection by use of the test pad.

Patent Literature 1 causes a problem such that the number of steps to produce a circuit board increases since detection of a wiring disconnection requires providing a light emitting element and a light receiving element separately.

Patent Literature 2 also causes a problem such that the number of steps to produce a circuit board increases since detection of a wiring disconnection requires providing a test pad separately.

In view of the circumstances, differently from, for example, Patent Literatures 1 and 2, Patent Literature 3 discloses the technique such that a circuit wiring disconnection and the like is detected in accordance with image data indicative of circuit wiring of an electronic circuit, so as to save the need to provide a circuit board with a member for detecting a disconnection.

### Citation List

Patent Literature 1
   Japanese Patent Application Publication, Tokukaisho, No. 60-125111 A (Publication Date: July 4, 1985)
Patent Literature 2
   Japanese Patent Application Publication, Tokukaisho, No. 60-170955 A (Publication Date: September 4, 1985)
Patent Literature 3
   Japanese Patent Application Publication, Tokukai, No. 2003-255008 A (Publication Date: September 10, 2003)

### Summary of Invention

### Technical Problem

However, the technique disclosed in Patent Literature 3 requires separately providing an apparatus for obtaining, from a circuit board, image data indicative of circuit wiring. This consequently causes a problem such that an apparatus for detecting a circuit wiring disconnection becomes larger.

In addition, according to the technique disclosed in Patent Literature 3, it is possible to check whether or not a disconnection occurs in circuit wiring but impossible to check whether or not faulty wiring occurs between elements.

The present invention has been made in view of the problems, and an object of the present invention is to provide an electronic circuit which is capable of properly detecting a circuit wiring disconnection and easily detecting faulty wiring between elements without the need of providing the electronic circuit with more components for detecting a circuit wiring disconnection.

### Solution to Problem

In order to attain the object, an electronic circuit of the present invention includes: a plurality of electronic parts, of the plurality of electronic parts, at least one electronic part being at least one main part and the other electronic parts being auxiliary parts, the at least one main part being necessary for determination of whether or not the electronic circuit operates normally, the auxiliary parts being unnecessary for determination of whether or not the electronic circuit operates normally, the auxiliary parts being connected to a line which is connected to the at least one main part so as to supply a signal necessary for operation of the at least one main part or output a signal obtained by the operation of the at least one main part.

According to the arrangement, the auxiliary parts that are unnecessary for determination of whether or not the electronic circuit operates normally are connected to the line to which the at least one main part that is necessary for determination of whether or not the electronic circuit operates normally is connected. This causes the auxiliary parts to supply a signal necessary for operation of the at least one main part or output a signal obtained by the operation of the at least one main part.

Since the auxiliary parts are the electronic parts that are unnecessary for determination of whether or not the electronic circuit operates normally, the electronic circuit itself seemingly operates normally even if a malfunction occurs in the auxiliary parts or a disconnection occurs in the line to the auxiliary parts. Therefore, a common operation check for an electronic circuit is insufficient to determine whether or not a malfunction occurs in the auxiliary parts or a disconnection occurs in the line to the auxiliary parts.

However, according to the arrangement, no signal is supplied to/from the at least one main part in a state where the auxiliary parts do not operate, e.g., in a state where a failure occurs in the auxiliary parts or a disconnection occurs in the line to the auxiliary parts. This prevents the electronic circuit from operating normally.

According to this, in a case where a common operation check for an electronic circuit determines that the electronic circuit does not operate normally, the case includes not only a case where a malfunction occurs in the at least one main part or a disconnection occurs in the line to the at least one main part but also a case where a malfunction occurs in the auxiliary parts or a disconnection occurs in the line to the auxiliary parts.

Accordingly, merely commonly checking whether or not the electronic circuit operates normally allows the case where a malfunction occurs in the auxiliary parts or a disconnection occurs in the respective lines to the auxiliary parts to serve as a cause for a case of abnormal operation of the electronic circuit. Therefore, it is unnecessary to separately carry out a test for detecting that a malfunction occurs in the auxiliary parts or a disconnection occurs in the respective lines to the auxiliary parts.

As described earlier, according to the arrangement, it is possible to make an electronic circuit which is capable of properly detecting a circuit wiring disconnection and easily detecting faulty wiring between elements without the need of providing the electronic circuit with more components for detecting a circuit wiring disconnection.

### Advantageous Effects of Invention

An electronic circuit of the present invention includes: a plurality of electronic parts, of the plurality of electronic parts, at least one electronic part being at least one main part and the other electronic parts being auxiliary parts, the at least one main part being necessary for determination of whether or not the electronic circuit operates normally, the auxiliary parts being unnecessary for determination of whether or not the electronic circuit operates normally, the auxiliary parts being connected to a line which is connected to the at least one main part so as to supply a signal necessary for operation of the at least one main part or output a signal obtained by the operation of the at least one main part. This yields an effect of making an electronic circuit which is capable of properly detecting a circuit wiring disconnection and easily detecting faulty wiring between elements without the need of providing the electronic circuit with more components for detecting a circuit wiring disconnection.

### Brief Description of Drawings

Fig. 1

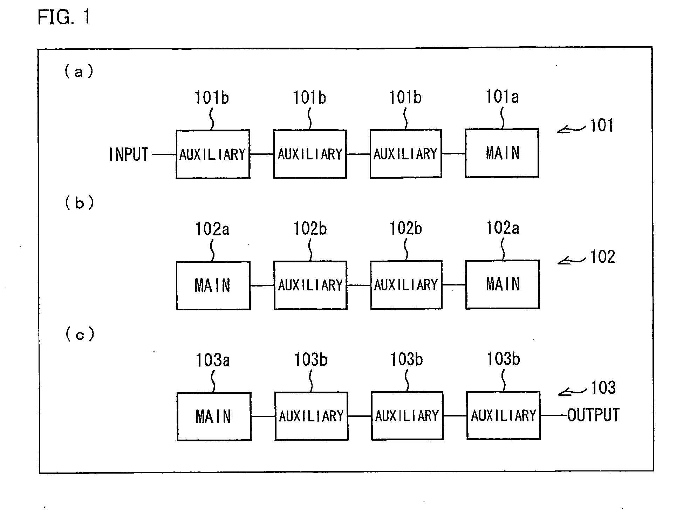

   Fig. 1 illustrates a characteristic part of circuit wiring of an electronic circuit of the present invention. (a) through (c) of Fig. 1 are schematic block diagrams illustrating characteristic features of the present invention.
Fig. 2

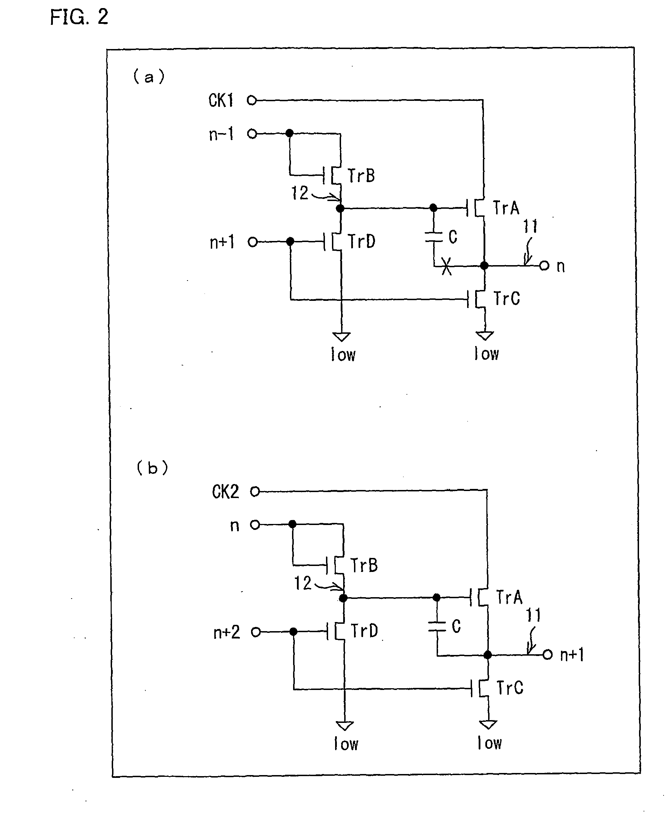

   Fig. 2 illustrates a comparative embodiment of a shift register circuit. (a) and (b) of Fig. 2 are circuit diagrams of the shift register circuit.
Fig. 3

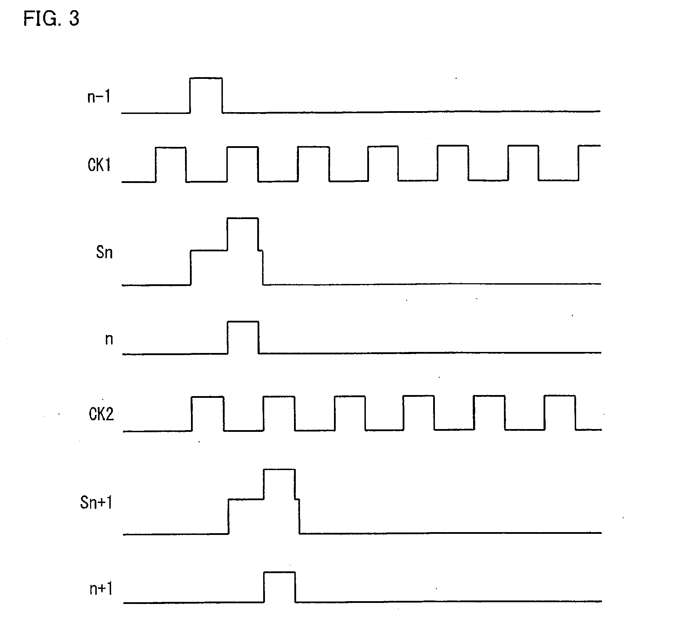

   Fig. 3 is a waveform chart illustrating an ideal waveform image in the shift register circuit illustrated in (a) and (b) of Fig. 2.
Fig. 4

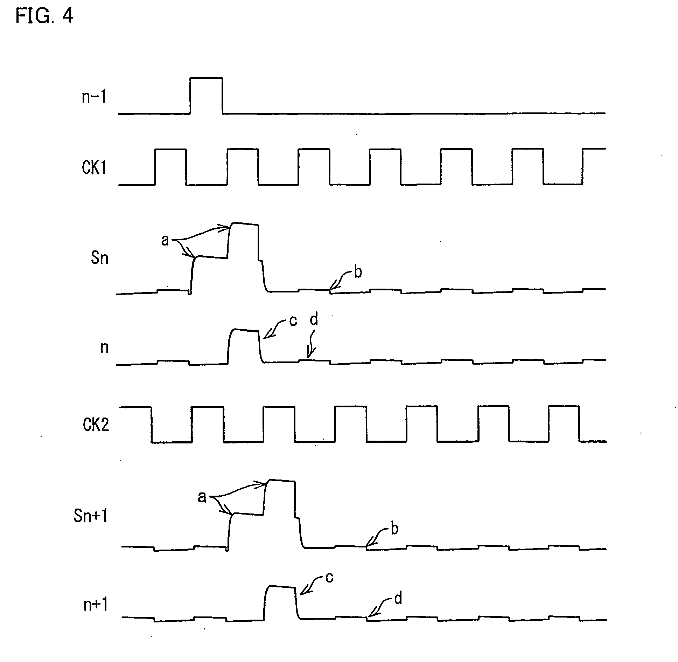

   Fig. 4 is a waveform chart illustrating an actual waveform image in the shift register circuit illustrated in (a) and (b) of Fig. 2.
Fig. 5

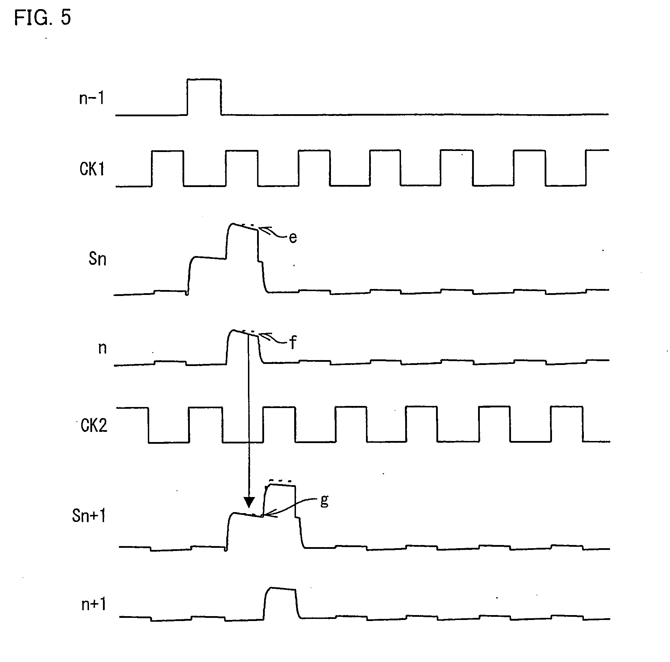

   Fig. 5 is a waveform chart illustrating a waveform image in the shift register circuit illustrated in (a) and (b) of Fig. 2, the waveform image being obtained when a disconnection occurs in wiring of a shift register illustrated in (a) of Fig. 2.
Fig. 6

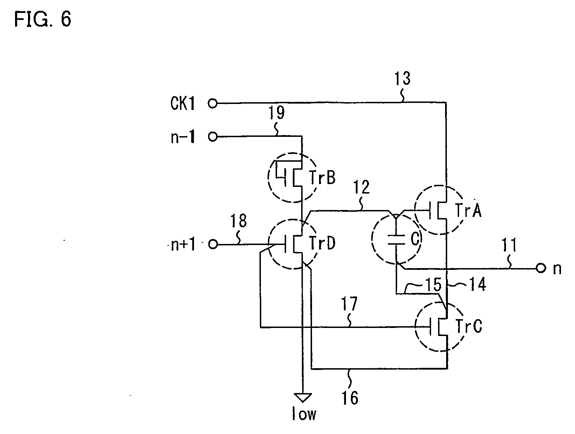

   Fig. 6 is a circuit diagram illustrating a shift register circuit in accordance with First Embodiment of the present invention.
Fig. 7

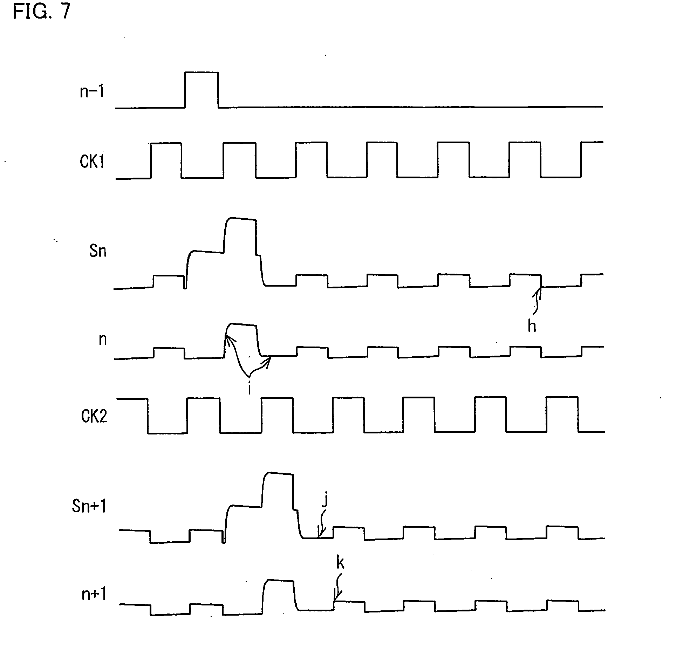

   Fig. 7 is a waveform chart illustrating an actual waveform image in the shift register circuit illustrated in Fig. 6.
Fig. 8

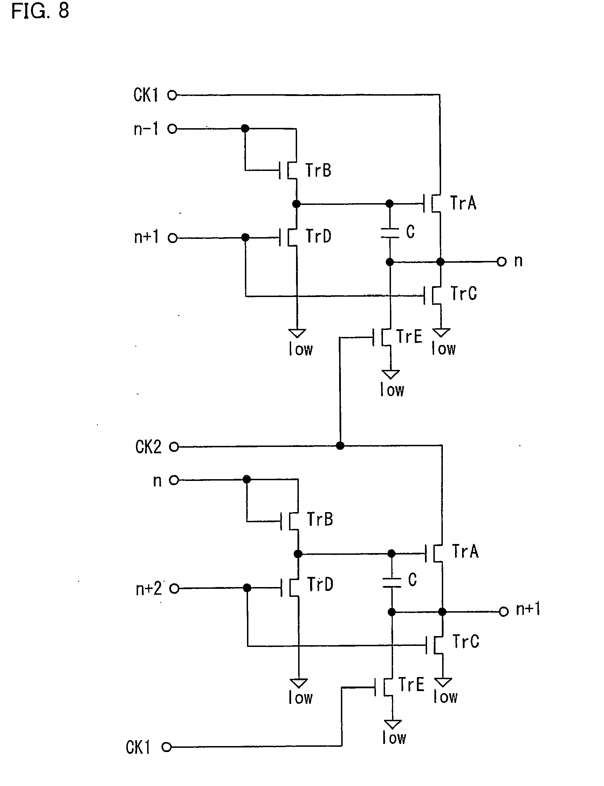

   Fig. 8 is a circuit diagram illustrating a shift register circuit arranged by adding one transistor to the shift register circuit illustrated in (a) and (b) of Fig. 2
Fig. 9

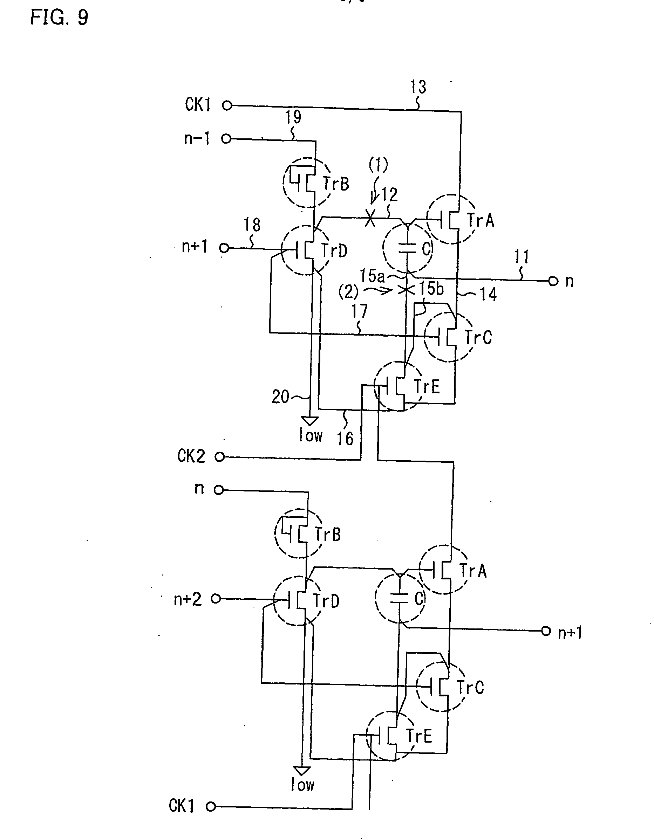

   Fig. 9 is a circuit diagram illustrating a shift register circuit in accordance with Second Embodiment of the present invention.

### Description of Embodiments

The following description discusses a characteristic part of circuit wiring of an electronic circuit of the present invention.
(a) of Fig. 1 illustrates a first circuit line 101 which is connected to an input (input terminal) of the circuit. (b) of Fig. 1 illustrates a second circuit line 102 provided in the circuit. (c) of Fig. 1 illustrates a third circuit line 103 which is connected to an output of the circuit.

The first circuit line 101 is a circuit line which connects three auxiliary parts 101b in series between the input and a main part 101a (see (a) of Fig. 1).

Note here that the main part 101a is an element such that the electronic circuit including the first circuit line 101 operates only when the main part 101a is connected to the first circuit line 101. Namely, the main part 101a is an electronic part (element) which is essential for implementation of a desired function of the electronic circuit.

Note also that the auxiliary parts 101b are electronic parts such that the electronic circuit including the first circuit line 101 may operate even when the auxiliary parts 101b are not connected to the first circuit line 101.

Since the electronic circuit may operate as a whole even when a disconnection occurs in the line that connects the auxiliary parts 101b, it is usually difficult to detect the disconnection.

However, as described earlier, in a case where the auxiliary parts 101b are connected in series between the input and the main part 101a which operates only when connected to the first circuit line 101, a disconnection of the line that connects the auxiliary parts 101b directly leads to a disconnection of the main part 101a. In such a case, a disconnection occurs in any of lines between the elements of the first circuit line 101 unless the main part 101a operates. This prevents the circuit including the first circuit line 101 from operating normally.

Namely, merely checking whether or not the circuit including the first circuit line 101 operates normally can determine whether or not a disconnection occurs in any of the lines between the elements of the first circuit line 101.

The above description discussed an example of the auxiliary parts 101b connected in series between the input and the main part 101a. Alternatively, it is possible to determine such a wiring disconnection as described above in case of circuit wiring (see a second circuit line 102 illustrated in (b) of Fig. 1) such that two auxiliary parts 102b are connected in series between main parts 102a provided in the circuit. Note here that each of the main parts 102a is identical in function to the main part 101a and each of the auxiliary parts 102b is identical in function to each of the auxiliary parts 101b.

Namely, regarding the second circuit line 102 as arranged above, as in the case of the first circuit line 101, merely checking whether or not the circuit including the second circuit line 102 operates normally can determine whether or not a disconnection occurs in any of lines between the elements of the second circuit line 102.

Alternatively, it is possible to determine such a wiring disconnection as described above in case of circuit wiring (see a third circuit line 103 illustrated in (c) of Fig. 1) such that three auxiliary parts 103b are connected in series between a main part 103a and an output. Note here that the main part 103a is identical in function to the main part 101a and each of the auxiliary parts 103b is identical in function to each of the auxiliary parts 101b.

Namely, regarding the third circuit line 103 as arranged above, as in the case of the third circuit line 103, merely checking whether or not the circuit including the third circuit line 103 operates normally can determine whether or not a disconnection occurs in any of lines between the elements of the third circuit line 103.

In a case where a disconnection occurs in wiring between elements (e.g., the auxiliary parts 101b) whose disconnection is difficult to detect in the circuit, it is generally possible to detect the disconnection only when a special test is carried out in a test environment which may adversely affect the elements. However, according to the circuit wiring as arranged above, merely determining whether or not a circuit including the circuit wiring operates normally can check whether or not a disconnection occurs in the circuit wiring. Therefore, it is unnecessary to carry out a special test.

As described earlier, according to the first circuit line 101, the second circuit line 102, and the third circuit line 103 as arranged above, the auxiliary parts 101b, 102b, and 103b that are unnecessary for determination of whether or not the electronic circuits including the respective circuit lines operate normally are connected to the respective circuit lines to which the main parts 101a, 102a, and 103a that are necessary for determination of whether or not the electronic circuits operate normally are connected. This causes the auxiliary parts 101b, 102b, and 103b to supply respective signals necessary for operation of the main parts 101a, 102a, and 103a or output respective signals obtained by operation of the main parts 101a, 102a, and 103a.

Since the auxiliary parts 101b, 102b, and 103b are the electronic parts that are unnecessary for determination of whether or not the electronic circuits operate normally, the electronic circuits themselves seemingly operate normally even if a malfunction occurs in the auxiliary parts 101b, 102b, and 103b or a disconnection occurs in the respective lines to the auxiliary parts 101b, 102b, and 103b. Therefore, a common operation check for an electronic circuit is insufficient to determine whether or not a malfunction occurs in the auxiliary parts 101b, 102b, and 103b or a disconnection occurs in the respective lines to the auxiliary parts 101b, 102b, and 103b.

However, according to the arrangement, no signals are supplied to/from the main parts 101a, 102a, and 103a in a state where the auxiliary parts 101b, 102b, and 103b do not operate, e.g., in a state where a failure occurs in the auxiliary parts 101b, 102b, and 103b or a disconnection occurs in the respective lines to the auxiliary parts 101b, 102b, and 103b. This prevents the electronic circuits from operating normally.

According to this, in a case where a common operation check for an electronic circuit determines that the electronic circuits do not operate normally, the case includes not only a case where a malfunction occurs in the main parts 101a, 102a, and 103a or a disconnection occurs in the respective lines to the main parts 101a, 102a, and 103a but also a case where a malfunction occurs in the auxiliary parts 101b, 102b, and 103b or a disconnection occurs in the respective lines to the auxiliary parts 101b, 102b, and 103b.

Accordingly, merely commonly checking whether or not the electronic circuits operate normally allows the case where a malfunction occurs in the auxiliary parts 101b, 102b, and 103b or a disconnection occurs in the respective lines to the auxiliary parts 101b, 102b, and 103b to serve as a cause for a case of abnormal operation of the electronic circuits. Therefore, it is unnecessary to separately carry out a test for detecting that a malfunction occurs in the auxiliary parts 101b, 102b, and 103b or a disconnection occurs in the respective lines to the auxiliary parts 101b, 102b, and 103b.

As described earlier, according to the arrangement, it is possible to make an electronic circuit which is capable of properly detecting a circuit wiring disconnection and easily detecting faulty wiring between elements without the need of providing the electronic circuit with more components for detecting a circuit wiring disconnection.

Note that for example, each of the circuit lines 101, 102, and 103 is one wiring line whose resistance is measurable at both ends thereof and at least two main parts mentioned above can be connected to the one wiring line.

Note here that circuit wiring of an electronic circuit of the present invention is to be specifically described. The following description uses, as an example, a shift register circuit included in an amorphous TFT (Thin Film Transistor) gate driver monolithic panel, so as to discuss the circuit wiring. The following description refers to a main part mentioned above as a main element and an auxiliary part mentioned above as an auxiliary element.

First, a comparative embodiment of a shift register circuit is described below.

Each of (a) and (b) of Fig. 2 illustrates a shift register circuit. (a) of Fig. 2 illustrates an nth shift register, and (b) of Fig. 2 illustrates an (n+1)th shift register. Note that, since the shift register circuit illustrated in (a) and (b) of Fig. 2 is a common circuit, a description thereof is omitted here.

In the shift register circuit, four transistors TrA, TrB, TrC, and TrD are main elements such that the shift register circuit operates normally when the main elements are connected to a line, and a condenser C is an auxiliary element such that the shift register circuit operates as the shift register circuit even when the auxiliary element is not connected to a line.

The nth shift register (see (a) of Fig. 2) obtains an output n by receiving inputs of (i) a clock signal CK1, (ii) an output (n-1) of an (n-1)th shift register, and (iii) an output (n+1) of the (n+1)th shift register.

As in the case of the nth shift register, the (n+1)th shift register (see (b) of Fig. 2) obtains the output (n+1) by receiving inputs of (i) a clock signal CK2, (ii) the output n of the nth shift register, and (iii) an output (n+2) of an (n+2)th shift register.

Namely, a certain shift register can obtain an output only when receiving inputs of (i) a clock signal, (ii) an output of a shift register followed by the certain shift register, and (iii) an output of a shift register following the certain shift register.

According to the shift register circuit as arranged above, in a case where a disconnection occurs in respective lines to the transistors TrA and TrB that are the main elements, the shift register circuit absolutely stops operating and thus no output is obtained. In a case where a disconnection occurs in respective lines to the transistors TrC and TrD, the shift register circuit continues operating but an abnormal output is obtained. Namely, in a case where a disconnection occurs in the respective lines to the main elements, the shift register circuit does not operate normally. This allows easy recognition that a disconnection occurs in the shift register circuit.

However, in a case where only an efficiency with which the elements are arranged is considered in the shift register circuit, a disconnection occurs easily at an X on an output line (output signal line) 11 which is connected to the condenser C (see (a) of Fig. 2). In this case, it may be impossible to detect, by a common operation check, that a malfunction occurs in the shift register circuit, which seemingly operates normally.

Namely, in a case where a disconnection occurs in the line to the condenser C which is the auxiliary element, a parasitic capacitor is defined to carry out a function of the condenser C in place of the condenser C depending on a size of each of the transistors. Therefore, the shift register circuit seemingly operates normally. In such a case, it is difficult to detect a wiring disconnection.

The following description discusses the problems with reference to waveform charts illustrated in Figs. 3 through 5.

In each of the waveform charts of Figs. 3 through 5, an internal line 12 is connected to a drain electrode of the transistor TrB constituting each shift register and a source electrode of the transistor TrD, and to a gate electrode of the transistor TrA and the condenser C.

Fig. 3 is a waveform chart illustrating an ideal waveform image in the shift register circuit illustrated in (a) and (b) of Fig. 2. As shown in the waveform chart illustrating an ideal waveform image, no distortion occurs in rises and falls during high periods of signals Sn and Sn+ 1 in the internal line 12 and output signals n and n+1, and these signals have low stable electric potentials during their low periods.

However, a waveform chart illustrated in Fig. 4 shows an actual waveform image. Namely, rise parts of high periods a are slightly distorted in the signals in the internal line 12 due to a wiring resistance and a capacitor. Also during low periods b in which electric potentials of the signals are supposed to be maintained at a low level, the electric potentials, which are influenced by the clock signals CK 1 and CK2, are not maintained at a low level.

In addition, in the waveform chart illustrated in Fig. 4, the output signals n and n+1 are influenced by the signals in the internal line 12 and a load of an output destination, so that rise parts of high periods c are distorted. This prevents electric potentials of the output signals from being maintained at a low level during low periods d in which the electric potentials are supposed to be maintained at a low level.

Note here that the waveform chart illustrated in Fig. 4 shows an actual waveform image obtained when no wiring disconnection occurs in the shift register circuit.

In contrast, a waveform chart illustrated in Fig. 5 shows a waveform image obtained when a disconnection occurs in the X part on the output line 11 of the condenser C in the shift register circuit illustrated in (a) of Fig. 2.

In the waveform chart illustrated in Fig. 5, a fall part of a high period e of the signal Sn in the internal line 12 slopes steeply toward a fall direction. This is because, since the condenser C does not function, an electric potential of the signal Sn cannot be retained and is then greatly reduced.

A fall part of a high period f of the output signal n also slopes steeply toward a fall direction due to the influence of the signal Sn in the internal line 12. In addition, the signal Sn+ 1 in the internal line 12 of the (n+1)th shift register affects a boundary region between a first half and a second half of a rise part of a high period g (causes the boundary to slope). However, since it is assumed that no disconnection occurs in the (n+1)th shift register following the nth shift register, the signal Sn does not affect (i) a fall during the high period of the signal Sn+1 in the internal line 12 of the (n+1)th shift register and (ii) the output signal n+1.

As described earlier, in the shift register circuit, a disconnection that occurs in the line to the condenser C which is the auxiliary element slightly affects the waveform image (see the waveform chart illustrated in Fig. 5). However, it is shown that the waveform image on the waveform chart illustrated in Fig. 5 is not so different from the waveform image on the waveform chart illustrated in Fig. 4 which waveform image is obtained when no disconnection occurs. This shows that it is difficult to detect a disconnection only by a common operation check for the shift register circuit.

In view of the circumstances, in order to securely determine whether or not a disconnection occurs in a line to such an auxiliary element, it is necessary to replace a common operation environment for a shift register circuit with an operation environment in which a test environment, a driving pulse period, and an electric potential are different in condition from those in the common operation environment. Such a special test environment, driving pulse, or electric potential adversely affects elements of the shift register circuit easily and may accelerate a deterioration in elements.

In view of the circumstances, a shift register circuit illustrated in Fig. 6 exemplifies circuit wiring such that well-designing wiring between elements while causing the shift register circuit to continue functioning as a shift register circuit makes it possible to easily and securely determine, by a common operation check, whether or not a disconnection occurs in a line to an auxiliary element.

### [First Embodiment]

Fig. 6 illustrates the shift register circuit which includes the elements of the nth shift register illustrated in (a) of Fig. 2 but in which wiring between elements is arranged differently from that of the shift register circuit illustrated in (a) of Fig. 2. In Fig. 6, dashed circles illustrate individual elements and branches in the dashed circles are wired via the individual elements.

In the shift register circuit illustrated in Fig. 6, only a condenser C which is an auxiliary element is connected to an output line 11 which is one (1) output line, and a transistor TrA and a transistor TrC which are main elements are not directly connected to the output line 11. Namely, the condenser C which is the auxiliary element is connected between the output line 11 and each of the transistor TrA and the transistor TrC which are the main elements.

The shift register circuit, which includes four transistors TrA, TrB, TrC, and TrD and one (1) condenser C, forms characteristic circuit wiring (see Fig. 6).

Namely, the transistor TrA has a source electrode that is connected to a line (an input signal line) 13 which is one (1) input line and to which a clock signal CK 1 is supplied, a gate electrode that is connected to an internal line 12, and a drain electrode that is connected, via a line 14, to a source electrode of the transistor TrC which is adjacent to the transistor TrA.

The transistor TrC has the source electrode that is connected to the line 14 and to one of terminals of the condenser C via a line 15. The line 14 and the line 15 thus branch off from the source electrode of the transistor TrC, so as to form branch lines.

The transistor TrC has a drain electrode that is connected to a drain electrode of the transistor TrD via a line 16 and a gate electrode that is connected to a gate electrode of the transistor TrD via a line 17. Note here that, since a line 18 to which an output signal n+1 of an (n+1)th shift register is supplied is connected to the gate electrode of the transistor TrD, the gate electrode of the transistor TrC to which the gate electrode of the transistor TrD is connected via the line 17 also receives the output signal n+ 1 supplied from the line 18 which is connected to the gate electrode of the transistor TrD.

The transistor TrD has a source electrode that is connected to a drain electrode of the transistor TrB which is adjacent to the transistor TrD and to the internal line 12. The internal line 12 thus branches off from the source electrode of the transistor TrD.

The transistor TrD has the drain electrode that is connected to a low level (low) and to the line 16. This maintains, at a low level, a signal outputted via the drain electrode of the transistor TrC and a signal outputted via the drain electrode of the transistor TrD.

Lastly, the transistor TrB has a source electrode that is connected to a line 19 to which an output signal n-1 is supplied from an (n-1)th shift register, a gate electrode that is connected to the line 19, and a drain electrode that is connected to the source electrode of the transistor TrD. Note here that, since the internal line 12 is connected to the source electrode of the transistor TrD as described earlier, an output signal is supplied from the drain electrode of the transistor TrB to the internal line 12.

In a case where the shift register circuit includes the circuit wiring as illustrated in Fig. 6, the transistor TrA, the transistor TrB, the transistor TrC, and the transistor TrD are cut off from input/output lines (the output line 11, the line 13, and the lines 18 and 19) or the internal line 12 when a disconnection occurs in any of lines between elements, that is, any of the output line 11, the internal line 12, and the other lines 13 through 19.

According to this, a disconnection in the lines to the respective elements of the shift register circuit directly leads to an abnormal output. Therefore, a driving test for the shift register circuit under a normal condition can determine whether or not a disconnection occurs. Namely, even when (i) a disconnection occurs in the line (the output line 11) to the condenser C which is the auxiliary element or (ii) a disconnection occurs in any of the lines of the shift register circuit, a common operation check can determine whether or not a disconnection occurs. This requires no special test that may cause a deterioration in element. Therefore, it is possible to make a longer-lived element and consequently to yield an effect of causing the shift register circuit to be long-lived and operate stably.

The shift register circuit including the circuit wiring illustrated in Fig. 6 adversely affects a signal in the internal lint 12 and an output signal n depending on external factors such as a temperature and a noise, capacitances of the circuit itself and an output destination, a driving period, a voltage, and other conditions, and such an adverse influence is great as described in the description of the waveform chart illustrated in Fig. 4 and showing the actual waveform image. For example, Fig. 7 is a waveform chart illustrating a waveform image obtained when the signals are adversely affected by a temperature rise.

When a temperature rise causes a reduction in off resistances of the respective transistors Tr, for example, an influence of the clock signal CK1 causes, via the transistor TrA, a low period h of a signal Sn in the internal line 12 and a low period i of the output signal n to be unstable, and the output signal n also affects a low period j of a signal in the internal line 12 of the (n+1)th shift register and a low period k of the output signal n+1 (see Fig. 7). When such an adverse influence is greater, a malfunction will occur in some nth shift register. Namely, as n is higher, an electric potential of a signal in the internal line 12 of the shift register circuit increases during a low period and an electric potential of an output signal increases during a low period. This finally causes a malfunction.

### [Second Embodiment]

In view of the circumstances, a shift register circuit illustrated in Fig. 8 is arranged to additionally include a transistor TrE so that a signal in an internal line has a stable low electric potential during its low period and an output signal has a stable low electric potential during its low period. The shift register circuit illustrated in Fig. 8 is arranged by adding the transistor TrE to the shift register circuit illustrated in (a) and (b) of Fig. 2.

The transistor TrE yields an effect of sinking, down to a low electric potential, an electric potential of an output signal n which electric potential is obtained during a low period by use of a clock signal CK2 of an (n+1)th shift register.

However, there occurs no operational problem in a case where the output signal n is stable (is affected but is operable) but a disconnection occurs, for example, in a line to the transistor TrE. Therefore, a common driving test for a shift register circuit cannot determine whether or not a disconnection occurs in the line to the transistor TrE.

In view of the circumstances, as in the case of the shift register circuit described in the First Embodiment and illustrated in Fig. 6, for example, a shift register circuit illustrated in Fig. 9 exemplifies circuit wiring such that well-designing wiring between elements makes it possible to easily and securely determine, by a common operation check, whether or not a disconnection occurs in the line to the transistor TrE.

The shift register circuit illustrated in Fig. 9 is different from the shift register circuit illustrated in Fig. 6 in that the shift register circuit illustrated in Fig. 9 has elements identical to those of the shift register circuit illustrated in Fig. 6 except the transistor TrE but wiring between elements is arranged differently from that of the shift register circuit illustrated in Fig. 6. In Fig. 9, dashed circles illustrate individual elements and branches in the dashed circles are wired via the individual elements.

Namely, the shift register circuit illustrated in Fig. 9 is arranged to further include the transistor TrE. The transistor TrE has a source electrode that is connected to a line 15a which is connected to one of terminals of a condenser C. The line 15a branches off from a drain electrode of the transistor TrE, so as to form a branch line. The line 15a is connected to a line 15b which is connected to a source electrode of a transistor TrC. A gate electrode of the transistor TrE receives the clock signal CK2 of the (n+1)th shift register.

The drain electrode of the transistor TrE is connected to a line 16 which is connected to a drain electrode of the transistor TrC. The line 16 is connected to a line 20 for sink-down which branches off from a drain electrode of a transistor TrD.

This maintains, at a low electric potential, the drain electrode of the transistor TrC, the drain electrode of the transistor TrD, and the drain electrode of the transistor TrE. Therefore, in the shift register circuit, a signal in an internal line can have a stable low electric potential during its low period and an output signal can have a stable low electric potential during its low period.

Note here that, in a case where a disconnection occurs in a part (1) on a line 12 in an nth shift register illustrated in Fig. 9, it follows that a transistor TrA does not operate. Therefore, no output signal n is outputted.

In a case where a disconnection occurs in a part (2) on the line 15a in the nth shift register illustrated in Fig. 9, that is, in a case where a disconnection occurs between the transistor TrA and an output terminal n, no signal is supplied to the output terminal n though the transistors TrA, TrC, and TrE operate normally.

According to this, a disconnection in the line to the transistor TrE of the shift register circuit directly leads to an abnormal output. Therefore, a driving test for the shift register circuit under a normal condition can determine whether or not the disconnection occurs.

Note that, since the shift register circuit illustrated in Fig. 9 includes the circuit wiring similar to that illustrated in Fig. 6, the transistor TrA, a transistor TrB, the transistor TrC, the transistor TrD, and the transistor TrE are cut off from input/output lines (an output line 11, a line 13, and lines 18 through 20) or the internal line 12 when a disconnection occurs in any of lines between elements, that is, any of the output line 11, the internal line 12, and the other lines 13 through 20.

According to this, a disconnection in the lines to the respective elements of the shift register circuit directly leads to an abnormal output. Therefore, a driving test for the shift register circuit under a normal condition can determine whether or not a disconnection occurs. Namely, even when (i) a disconnection occurs in the line (the output line 11) to the condenser C which is the auxiliary element or (ii) a disconnection occurs in any of the lines of the shift register circuit, a common operation check can determine whether or not a disconnection occurs. This requires no special test that may cause a deterioration in element. Therefore, it is possible to make a longer-lived element and consequently to yield an effect of causing the shift register circuit to be long-lived and operate stably.

According to the above description, a member such as a transistor TrA is used in a shift register circuit (an electronic circuit) as a main part to function in the shift register circuit. However, the present invention is not limited to this. A dedicated electronic part can be used as the main part to determine whether or not the shift register circuit (electronic circuit) operates normally.

In this case, in a case where lines arranged with respect to a plurality of input signals are integratedly connected to a dedicated element which is a dedicated electronic part, it is possible to yield an effect of reducing the number of malfunction checks.

As described earlier, the above description discussed an example of application of circuit wiring of the present invention to a shift register circuit in a driving circuit for driving a TFT panel..However, the present invention is not limited to this. For example, the present invention is also applicable to wiring between electronic parts in a relationship between a main element and an auxiliary element.

For example, the present invention is applicable not only to an amorphous TFT gate driver monolithic panel (described earlier), not to mention other flat panel display driving circuits but also to any circuit provided on a substrate (regardless of how elements are formed and provided).

Further, in a case where a main part is wired via an auxiliary part, it is possible to detect faulty wiring and the like easily in what includes actual wiring but is not necessarily provided on a substrate such as wiring in an automobile, wiring in equipment, and electric appliances. Similarly, the present invention can also be carried out with respect to an electronic device including a plurality of electronic parts.

An electronic circuit of the present invention include: a plurality of electronic parts, of the plurality of electronic parts, at least one electronic part being at least one main part (101a, 102a, and 103a) and the other electronic parts being auxiliary parts (101b, 102b, and 103b), the at least one main part (101a, 102a, and 103a) being necessary for determination of whether or not the electronic circuit operates normally, the auxiliary parts (101b, 102b, and 103b) being unnecessary for determination of whether or not the electronic circuit operates normally, the auxiliary parts (101b, 102b, and 103b) being connected to a line which is connected to the at least one main part (101a, 102a, and 103a) so as to supply a signal necessary for operation of the at least one main part (101a, 102a, and 103a) or output a signal obtained by the operation of the at least one main part.

According to the arrangement, the auxiliary parts that are unnecessary for determination of whether or not the electronic circuit operates normally are connected to the line to which the at least one main part that is necessary for determination of whether or not the electronic circuit operates normally is connected. This causes the auxiliary parts to supply a signal necessary for operation of the at least one main part or output a signal obtained by the operation of the at least one main part.

Since the auxiliary parts (101b, 102b, and 103b) are the electronic parts that are unnecessary for determination of whether or not the electronic circuit operates normally, the electronic circuit itself seemingly operates normally even if a malfunction occurs in the auxiliary parts or a disconnection occurs in the line to the auxiliary parts. Therefore, a common operation check for an electronic circuit is insufficient to determine whether or not a malfunction occurs in the auxiliary parts or a disconnection occurs in the line to the auxiliary parts.

However, according to the arrangement, no signal is supplied to/from the at least one main part (101a, 102a, and 103a) in a state where the auxiliary parts (101b, 102b, and 103b) do not operate, e.g., in a state where a failure occurs in the auxiliary parts or a disconnection occurs in the line to the auxiliary parts. This prevents the electronic circuit from operating normally.

According to this, in a case where a common operation check for an electronic circuit determines that the electronic circuit does not operate normally, the case includes not only a case where a malfunction occurs in the at least one main part or a disconnection occurs in the line to the at least one main part but also a case where a malfunction occurs in the auxiliary parts or a disconnection occurs in the line to the auxiliary parts.

Accordingly, merely commonly checking whether or not the electronic circuit operates normally allows the case where a malfunction occurs in the auxiliary parts or a disconnection occurs in the respective lines to the auxiliary parts to serve as a cause for a case of abnormal operation of the electronic circuit. Therefore, it is unnecessary to separately carry out a test for detecting that a malfunction occurs in the auxiliary parts or a disconnection occurs in the respective lines to the auxiliary parts.

As described earlier, according to the arrangement, it is possible to make an electronic circuit which is capable of properly detecting a circuit wiring disconnection and easily detecting faulty wiring between elements without the need of providing the electronic circuit with more components for detecting a circuit wiring disconnection.

The at least one main part (101a, 102a, and 103a) may be an essential electronic part for implementing a desired function of the electronic circuit.

In this case, since it is unnecessary to newly provide an electronic part, a circuit can be prevented from being larger by being subjected to a test for detecting a malfunction such as a disconnection.

The at least one main part (101a, 102a, and 103a) may be a dedicated electronic part for determining whether or not the electronic circuit operates normally.

In this case, since a dedicated electronic part is used, it is possible to arrange wiring more easily as compared to a case where an existing electronic part mentioned above is used.

The line may be an input signal line; and the auxiliary parts (101b, 102b, and 103b) may be connected between the at least one main part (101a, 102a, and 103a) and a signal input terminal of the input signal line.

In this case, whether or not a signal necessary for operation of the at least one main part is supplied can determine whether or not a disconnection occurs.

The input signal line may be one input line; and only one of the at least one main part (101a, 102a, and 103a) may be connected to the one input line.

In this case, arrangement of the one input line with respect to one input signal causes the only one of the at least one main part to be cut off from the one input line when a disconnection occurs. Therefore, detection of only one symptom of malfunction can determine whether or not a disconnection occurs.

The input signal line may be one input line; and when the at least one main part (101a, 102a, and 103a) is at least one dedicated electronic part, the at least one dedicated electronic part may operate in response to a plurality of input signals, and the at least one dedicated electronic part may be smaller in number than input lines.

In this case, in a case where lines arranged with respect to a plurality of input signals are integratedly connected to a dedicated element which is a dedicated electronic part, it is possible to reduce the number of malfunction checks.

The input signal line may be one line having at least two branch lines which branch off from a side of the input signal line via which side no signal is inputted; and the auxiliary parts (101b, 102b, and 103b) may be connected to at least one of the at least two branch lines, and the at least one main part (101a, 102a, and 103a) may be connected to the other of the at least two branch lines.

In this case, it is possible to detect a wiring disconnection even when it is difficult to arrange wiring with respect to electronic parts in terms of a configuration of an electronic circuit.

The line may be an output signal line; and the auxiliary parts (101b, 102b, and 103b) may be connected between the at least one main part (101a, 102a, and 103a) and a signal output terminal of the output signal line.

In this case, whether or not a signal of the at least one main part is outputted can determine whether or not a disconnection occurs.

The output signal line may be one output line; and only one of the at least one main part (101a, 102a, and 103a) may be connected to the one output line.

In this case, arrangement of the one output line with respect to one output signal causes the only one of the at least one main part to be cut off from the one output line when a disconnection occurs. Therefore, detection of only one symptom of malfunction can determine whether or not a disconnection occurs.

The output signal line may be one output line; and when the at least one main part (101a, 102a, and 103a) is at least one dedicated electronic part, the at least one dedicated electronic part may operate in response to a plurality of input signals, and the at least one dedicated electronic part may be smaller in number than output lines.

In this case, in a case where lines arranged with respect to a plurality of input signals are integratedly connected to a dedicated element which is a dedicated electronic part, it is possible to reduce the number of malfunction checks.

The output signal line may be one line having at least two branch lines which branch off from a side of the output signal line via which side no signal is outputted; and the auxiliary parts (101b, 102b, and 103b) may be connected to at least one of the at least two branch lines, and the at least one main part (101a, 102a, and 103a) may be connected to the other of the at least two branch lines.

In this case, it is possible to detect a wiring disconnection even when it is difficult to arrange wiring with respect to electronic parts in terms of a configuration of an electronic circuit.

The line may be connected to neither of input and output terminals of the electronic circuit; and two of the at least one main part may be connected to the line, and the auxiliary parts (101b, 102b, and 103b) may be connected between the two main parts.

At least one of the two main parts may be a dedicated electronic part for determining whether or not the electronic circuit operates normally.

The line may be one wiring line whose resistance is measurable at both ends thereof; and at least two of the at least one main part (101a, 102a, and 103a) may be connected to the one wiring line.

In this case, it is possible to reduce the number of malfunction checks when resistance measurement is carried out at both ends of a line.

At least one of the at least two main parts (101a, 102a, and 103a) may be a dedicated electronic part for determining whether or not the electronic circuit operates normally.

An electronic device may include an electronic circuit as arranged above.

For example, an electronic device may be arranged such that an electronic circuit is applied among a plurality of circuit boards (e.g., between a TFT substrate and a printed circuit board or to a circuit including a plurality of substrates).

An electronic device may also be arranged such that in arranging actual wiring with respect to, for example, mechanical equipment, an electronic circuit is applied to a method for connecting devices.

An electronic device may also be arranged such that an electronic circuit is provided in, for example, a circuit board, and devices/mechanical equipment in a complex manner.

The present invention is not limited to the description of the embodiments above, but may be altered by a skilled person within the scope of the claims. An embodiment based on a proper combination of technical means disclosed in different embodiments is encompassed in the technical scope of the present invention.

### Industrial Applicability

The present invention is usable for a general electronic circuit including a plurality of electronic parts.

### Reference Signs List

- 11: Output line
- 12: Internal line
- 13: Line
- 14: Line
- 15: Line
- 16: Line
- 17: Line
- 18: Line
- 19: Line
- 20: Line
- 101: First circuit line
- 101a: Main part
- 101b: Auxiliary part
- 102: Second circuit line
- 102a: Main part
- 102b: Auxiliary part
- 103: Third circuit line
- 103a: Main part
- 103b: Auxiliary part
- C: Condenser
- CK 1: Clock signal
- CK2: Clock signal
- n: Output signal
- Sn: Signal
- TrA: Transistor
- TrB: Transistor
- TrC: Transistor
- TrD: Transistor
- TrE: Transistor

## Claims

1. An electronic circuit comprising:
a plurality of electronic parts,
of the plurality of electronic parts, at least one electronic part being at least one main part and the other electronic parts being auxiliary parts,
the at least one main part being necessary for determination of whether or not the electronic circuit operates normally,
the auxiliary parts being unnecessary for determination of whether or not the electronic circuit operates normally,
the auxiliary parts being connected to a line which is connected to the at least one main part so as to supply a signal necessary for operation of the at least one main part or output a signal obtained by the operation of the at least one main part.

2. The electronic circuit as set forth in claim 1, wherein the at least one main part is an essential electronic part for implementing a desired function of the electronic circuit.

3. The electronic circuit as set forth in claim 1, wherein the at least one main part is a dedicated electronic part for determining whether or not the electronic circuit operates normally.

4. The electronic circuit as set forth in any one of claims 1 through 3, wherein:
the line is an input signal line; and
the auxiliary parts are connected between the at least one main part and a signal input terminal of the input signal line.

5. The electronic circuit as set forth in claim 4, wherein:
the input signal line is one input line; and
only one of the at least one main part is connected to the one input line.

6. The electronic circuit as set forth in claim 4, wherein:
the input signal line is one input line; and
when the at least one main part is at least one dedicated electronic part,
the at least one dedicated electronic part operates in response to a plurality of input signals, and
the at least one dedicated electronic part is smaller in number than input lines.

7. The electronic circuit as set forth in claim 2, wherein:
the line is an input signal line;
the input signal line is one line having at least two branch lines which branch off from a side of the input signal line via which side no signal is inputted; and
the auxiliary parts are connected to at least one of the at least two branch lines, and the at least one main part is connected to the other of the at least two branch lines.

8. The electronic circuit as set forth in any one of claims 1 through 3, wherein:
the line is an output signal line; and
the auxiliary parts are connected between the at least one main part and a signal output terminal of the output signal line.

9. The electronic circuit as set forth in claim 8, wherein:
the output signal line is one output line; and
only one of the at least one main part is connected to the one output line.

10. The electronic circuit as set forth in claim 8, wherein:
the output signal line is one output line; and
when the at least one main part is at least one dedicated electronic part,
the at least one dedicated electronic part operates in response to a plurality of input signals, and
the at least one dedicated electronic part is smaller in number than output lines.

11. The electronic circuit as set forth in claim 2, wherein:
the line is an output signal line;
the output signal line is one line having at least two branch lines which branch off from a side of the output signal line via which side no signal is outputted; and
the auxiliary parts are connected to at least one of the at least two branch lines, and the at least one main part is connected to the other of the at least two branch lines.

12. The electronic circuit as set forth in claim 1, wherein:
the line is connected to neither of input and output terminals of the electronic circuit; and
two of the at least one main part are connected to the line, and the auxiliary parts are connected between the two main parts.

13. The electronic circuit as set forth in claim 12, wherein at least one of the two main parts is a dedicated electronic part for determining whether or not the electronic circuit operates normally.

14. The electronic circuit as set forth in claim 1, wherein:
the line is one wiring line whose resistance is measurable at both ends thereof; and
at least two of the at least one main part are connected to the one wiring line.

15. The electronic circuit as set forth in claim 14, wherein at least one of the at least two main parts is a dedicated electronic part for determining whether or not the electronic circuit operates normally.

16. An electronic device comprising an electronic circuit recited in any one of claims 1 through 15.
